# EUROPEAN PATENT APPLICATION

(11) **EP 1 512 485 A1**
(43) Date of publication of application: **09.03.2005**
(21) Application number: 04018953.2
(22) Date of filing: 10.08.2004
(51) Int. Cl.: B23K 20/10, H01L 21/607, H05K 13/04, B29C 65/64, B29C 65/08

(54) **Method and apparatus for mounting electronic part applying ultrasonic vibrating in a plurality of directions, and electronic circuit apparatus**

(30) Priority: 03.09.2003 JP 2003311593
(71) Applicant: Kabushiki Kaisha Toshiba, Tokyo 105-8001 (JP)
(72) Inventor: Sawano, Mitsutoshi, c/o Toshiba Corporation, Minato-ku Tokyo 105-8001 (JP); Takahashi, Kuniaki, c/o Toshiba Corporation, Minato-ku Tokyo 105-8001 (JP); Hosoda, Kuniyasu, c/o Toshiba Corporation, Minato-ku Tokyo 105-8001 (JP)
(74) Representative: Henkel, Feiler & Hänzel

(57) **Abstract**

An electronic part (20) is mounted on a circuit board (10) by ultrasonically vibrating horns in a plurality of directions in the plane of a bonding surface (20a) of the electronic part (20) to be mounted on a to-be-bonded surface (10a) of the circuit board (10).

## Description

The present invention relates to an electronic part mounting apparatus, an electronic part mounting method and an electronic circuit apparatus, to which a technique for mounting an electronic part, such as a semiconductor chip, to a circuit board using ultrasonic vibrations is applied.

Conventionally, two methods are known as techniques for mounting an electronic part, such as a semiconductor chip, to a circuit board with ultrasonic vibrations. In one technique, a horn is ultrasonically vibrated in one direction in a plane of a bonding surface of an electronic part, that is, in the bonding surface direction, while the electronic part is bonded to and mounted on the circuit board. In the other technique, a horn is ultrasonically vibrated in a direction perpendicular (vertical) to a bonding surface of an electronic part, while the electronic part is bonded to and mounted on the circuit board (see, for example, Jpn. Pat. Appln. KOKAI Publication No. 2002-210409).

The former technique has the problem that the bonding strength greatly varies depending on the direction of vibrations and the pattern arrangement direction of the bonding portion on a surface of the circuit board to be bonded with the electronic part. The latter technique has the problem that, since ultrasonic vibrations are applied to a flat thin (chip-shaped) electronic part in the direction perpendicular to the surface thereof, the part may be frequently damaged when or after mounting, resulting in low reliability of circuit operations.

As described above, in the conventional techniques for mounting an electronic part such as a semiconductor chip to a surface of a circuit board by using ultrasonic vibrations, there are problems of the variance in bonding strength, the high frequency of damages in the part mounted on the board, the low reliability of circuit operations, etc.

The present invention has been made in consideration of the above situations. An object of the invention is to provide an electronic part mounting apparatus and an electronic part mounting method which can mount an electronic part to a circuit board with a stable and highly reliable part-bonding strength without an influence of mounting conditions, parts to be mounted, etc.

Another object of the present invention is to provide an electronic circuit apparatus, by which stable and highly reliable circuit operations are always expected.

To achieve the above objects, according to the present invention, there is provided an electronic part mounting apparatus characterized by comprising pressurizing means for pressurizing a bonding surface of an electronic part to a to-be-bonded surface of a circuit board, while holding the electronic part to be mounted on the circuit board, and vibration applying means for applying vibrations in a plurality of directions in a plane of the bonding surface of the electronic part, while holding the electronic part, and the pressurizing means and the vibration applying means bond the bonding surface of the electronic part to the to-be-bonded surface of the circuit board, thereby mounting the electronic part on the circuit board.

In short, the present invention provides a bonding technique of applying ultrasonic vibrations in a plurality of directions in one plane. This bonding technique prevents a chip-like electronic part from being damaged by ultrasonic vibrations applied in a (vertical) direction perpendicular to the bonding surface of the electronic part. Therefore, the yield of ultrasonic bonding can be improved, and the reliable and stable circuit operation can be expected. In addition, since the directions of the vibrations are varied in a plane of the bonding surface of the electronic part, electronic part can be mounted stably and reliably at a high uniform bonding strength relative to the pattern arrangement in all directions.

This summary of the invention does not necessarily describe all necessary features so that the invention may also be a sub-combination of these described features.

The invention can be more fully understood from the following detailed description when taken in conjunction with the accompanying drawings, in which:
FIG. 1A is a diagram showing a structure of an electronic part mounting apparatus according to an embodiment of the present invention.
FIG. 1B is a perspective view showing an ultrasonic bonding tool of the electronic part mounting apparatus of the embodiment.
FIG. 2 is a signal waveform diagram showing an example of a drive signal used in the electronic part mounting apparatus of the embodiment.
FIG. 3 is a diagram for explaining the bonding strength of the electronic part mounting apparatus of the embodiment.
FIG. 4 is a signal waveform diagram showing an example of a drive signal used in the electronic part mounting apparatus of the embodiment.
FIG. 5 is a signal waveform diagram showing another example of a drive signal used in the electronic part mounting apparatus of the embodiment.
FIG. 6 is a signal waveform diagram showing still another example of a drive signal used in the electronic part mounting apparatus of the embodiment.

An embodiment of the present will be described with reference to the accompanying drawings.

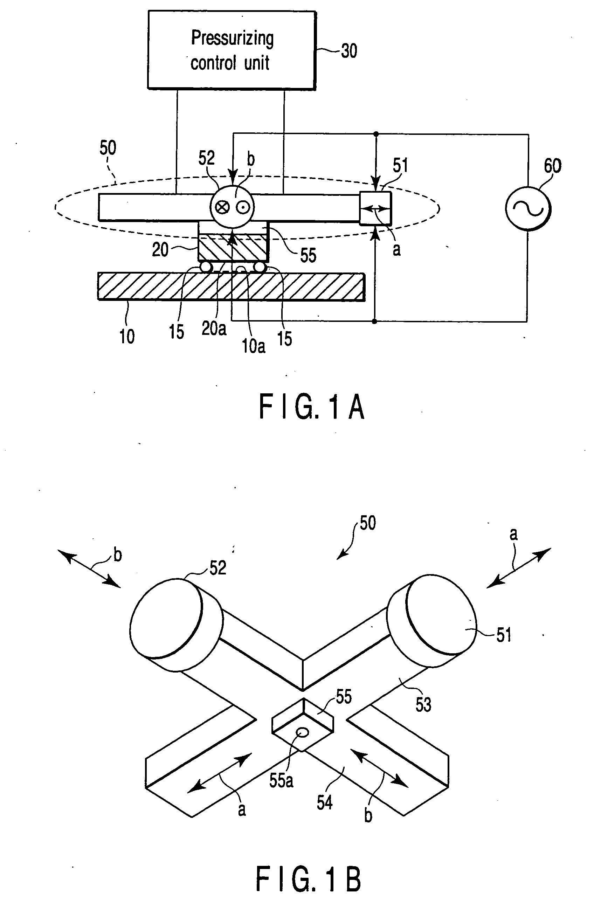

FIG. 1A shows a structure of an electronic part mounting apparatus according to an embodiment of the present invention. The electronic part mounting apparatus, to which the present invention is applied, may be, for example, an ultrasonic flip-chip bonding apparatus.

The electronic part mounting apparatus according to the embodiment comprises, as shown in FIG. 1A, a pressurizing control unit 30, an ultrasonic bonding tool 50 and an ultrasonic vibration control circuit 60 including an oscillator.

When an electronic part 20 is to be mounted on a circuit board 10, a bonding surface 20a of the electronic part 20 is held to a to-be-bonded surface 10a of the circuit board 10 by attraction. force through a nozzle 55 of the ultrasonic bonding tool 50. In this state, the pressurizing control unit 30 pressurizes the electronic part 20 at a predetermined pressure to bond the bonding surface 20a to the to-be-bonded surface 10a.

As shown in FIG. 1B, the'ultrasonic bonding tool 50 comprises a first horn 53 and a second horn 54, which are crossed. Further, it comprises a first ultrasonic vibrator 51 provided at an end of the first horn 53 in the longitudinal direction, a second ultrasonic vibrator 52 provided at an end of the second horn 54 in the longitudinal direction, and a nozzle 55 provided on a lower surface of an intersection portion of the first horn 53 and the second horn 54. The nozzle 55 has, at its distal end, a vacuum attraction port (attraction hole) 55a to vacuum the electronic part 20 to be mounted on the to-be-bonded surface 10a of the circuit board 10, so that the electronic part 20 can be held to the nozzle surface in place.

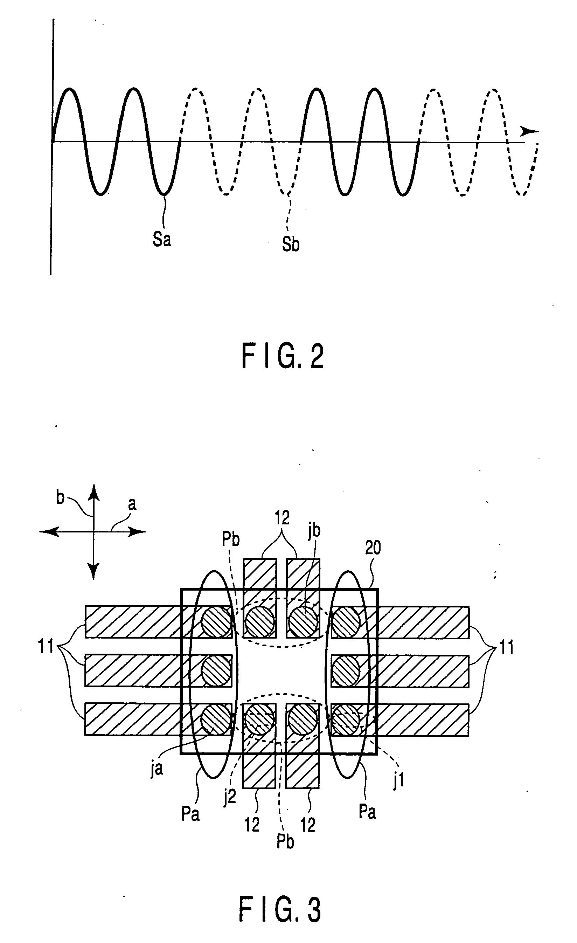

The ultrasonic vibration control circuit 60 includes the oscillator, and supplies ultrasonic drive signals of a predetermined frequency (e.g., about 60 KHz) respectively to the first ultrasonic vibrator 51 provided on the first horn 53 and the second ultrasonic vibrator 52 provided on the second horn 54 of the ultrasonic bonding tool 50. For example, a driving signal (Sa) indicated by solid lines in FIG. 2 is supplied to the first ultrasonic vibrator 51, and a signal (Sb) indicated by broken lines in FIG. 2 is supplied to the second ultrasonic vibrator 52. As a result, the first ultrasonic vibrator 51 and the second ultrasonic vibrator 52 are alternately driven in a predetermined time unit. With this drive control, the first ultrasonic vibrator 51 applies ultrasonic vibrations to the first horn 53 in accordance with the drive signal (Sa) in the direction indicated by the arrow a, and the second ultrasonic vibrator 52 applies ultrasonic vibrations to the second horn 54 in accordance with the drive signal (Sb) in the direction indicated by the arrow b. The directions of the vibrations indicated by the arrows a and b are parallel to the bonding surface 20a of the electronic part 20 (i.e., in the direction of the bonding surface 20a). Bumps (for example, gold-plated bumps) provided on the to-be-bonded surface 10a of the circuit board 10 and bumps provided on the bonding surface 20a of the electronic part 20 are both denoted by a numeral 15.

In the electronic part mounting apparatus having the above configuration, when the electronic part 20 is to be mounted on the to-be-bonded surface of the circuit board 10, the bonding surface 20a of the electronic part 20 is vacuumed to the nozzle 55 of the ultrasonic bonding tool 50 and held to bonding tool 50 in place. In this state, the electronic part 20 is pressurized at a predetermined pressure, and the bonding surface 20a is bonded to the to-be-bonded surface 10a.

In parallel with this pressurization, the ultrasonic vibration control circuit 60 including the oscillator supplies ultrasonic drive signals to the first ultrasonic vibrator 51 and the second ultrasonic vibrator 52 of the ultrasonic bonding tool 50. The first ultrasonic vibrator 51 applies ultrasonic vibrations in the direction indicated by the arrow a to the first horn 53. The second ultrasonic vibrator 52 applies ultrasonic vibrations in the direction indicated by the arrow b to the second horn 54.

For example, the ultrasonic driving signal (Sa) indicated by the solid lines in FIG. 2 is supplied to the first ultrasonic vibrator 51, and the ultrasonic driving signal (Sb) indicated by the broken lines in FIG. 2 is supplied to the second ultrasonic vibrator 52. As a result, the first ultrasonic vibrator 51 and the second ultrasonic vibrator 52 are alternately driven in a predetermined time unit.

By this drive control, the first ultrasonic vibrator 51 applies ultrasonic vibrations to the first horn 53 in accordance with the drive signal (Sa) in the direction indicated by the arrow a, and the second ultrasonic vibrator 52 applies ultrasonic vibrations to the second horn 54 in accordance with the drive signal (Sb) in the direction indicated by the arrow b.

With the ultrasonic vibrations of the first horn 53 and the second horn 54, the bonding surface 20a of the electronic part 20 held to the nozzle 55 of the ultrasonic bonding tool 50 alternately receives the ultrasonic vibrations in the directions indicated by the arrows a and b. The bonding surface 20a of the electronic part 20 is bonded to the to-be-bonded surface 10a of the circuit board 10 by the ultrasonic vibrations in the respective directions. As a result, the electronic part 20 is mounted on the circuit board 10.

In the above bonding process, the bonding surface 20a of the electronic part 20 is bonded to the to-be-bonded surface 10a of the circuit board 10 without receiving vibrations in the (vertical) direction perpendicular to the bonding surface 20a. Therefore, excess vibrations are not applied to the upper and lower surfaces of the electronic part 20. Consequently, the electronic part 20 is prevented from being damaged, so that the yield of ultrasonic bonding can be improved. Moreover, since excess vibrations are not applied to the electronic part 20, the reliable and stable circuit operation can be maintained after the part is mounted.

Further, the bonding surface 20a of the electronic part 20 receives ultrasonic vibrations parallel with the bonding surface 20a alternately in the directions of the arrows a and b, when it is bonded to the to-be-bonded surface 10a of the circuit board 10. Therefore, the bonding strength of the part can be kept uniform with respect to the pattern arrangement provided on the to-be-bonded surface 10a of the circuit board 10 in all directions.

The bonding strength of the part, which differs relative to the pattern arrangement, is shown in FIG. 3. Assume that wiring patterns 11 and 12 are provided on the respective sides (four sides) of the to-be-bonded surface 10a of the circuit board 10 on which the electronic part 20 is to be mounted. When the wiring patterns 11 and 12 are bonded to the bonding surface 20a of the electronic part 20 by ultrasonic vibration in only the direction of the arrow a, bonding surfaces (j1) of bumps sufficient for the required bonding strength are formed on the wiring patterns 11 extending in the direction of vibrations (the direction of the arrow a). However, as regards the wiring patterns 12, since the vibrations are in the width direction of the pattern, bonding surfaces (j2) of bumps cannot be sufficient for the required bonding strength. Thus, the bonding strength in the bonding part Pa is sufficient, but the bonding strength in the bonding part Pb is not. On the other hand, when the bonding surface 20a of the electronic part 20 is bonded to the to-be-bonded surface 10a of the circuit board 10 by ultrasonic vibrations in the directions of the arrows a and b, bonding surfaces (ja, jb) of the bumps are sufficient for the required bonding strength with respect to both the wiring patterns 11 and 12. Thus, all the wiring patterns 11 and 12 can be bonded with uniform bonding strength. Note that the circuit board 10, on which the electronic part 20 is bonded, is not limited to a rigid board, but may be a flexible board.

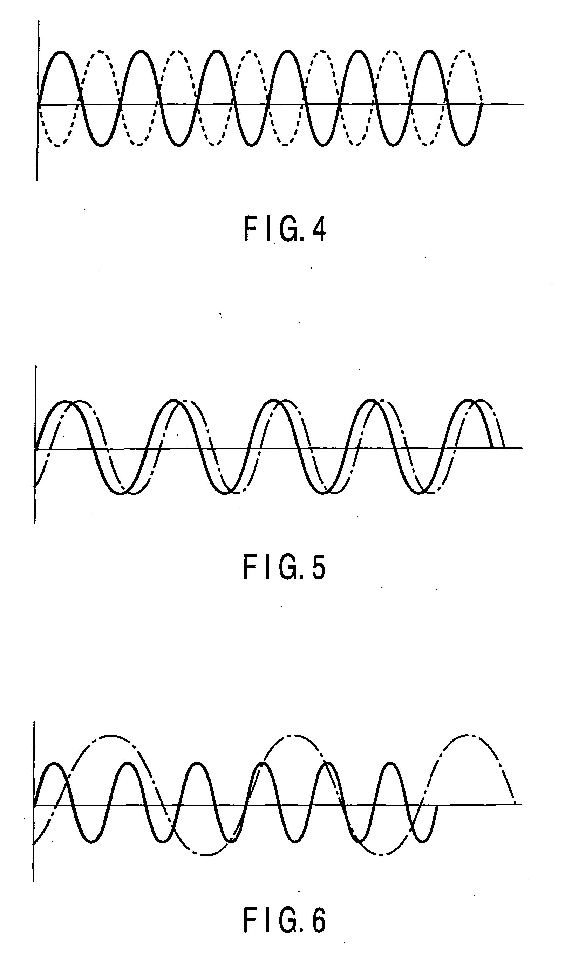

In the embodiment described above, the first ultrasonic vibrator 51 and the second ultrasonic vibrator 52 are alternately driven discontinuously in accordance with the drive signals (Sa, Sb) shown in FIG. 2. However, for example, the first ultrasonic vibrator 51 may be driven by a drive signal indicated by the solid line shown in FIG. 4, while the second ultrasonic vibrator 52 may be driven by a drive signal indicated by the broken line shown in FIG. 4, thereby applying ultrasonic vibrations to the bonding surface 20a of the electronic part 20 in a circular direction in the surface.

Alternatively, as shown in FIG. 5, the first ultrasonic vibrator 51 may be driven by a drive signal indicated by the solid line, while the second ultrasonic vibrator 52 may be driven by a drive signal indicated by the dot-chain line, thereby applying ultrasonic vibrations to the bonding surface 20a of the electronic part 20 in an elliptical direction parallel to the surface.

Alternatively, the first ultrasonic vibrator 51 may be driven by a drive signal indicated by the solid line shown in FIG. 6, while the second ultrasonic vibrator 52 may be driven by a drive signal indicated by the dot-chain line shown in FIG. 6, thereby applying ultrasonic vibrations to the bonding surface 20a of the electronic part 20 in an indefinite vector direction parallel to the surface.

The ultrasonic vibrations in accordance with any of the drive signals described above realize a bonding apparatus, which bonds the bonding surface 20a of the electronic part 20 to the to-be-bonded surface 10a of the circuit board 10, by ultrasonically vibrating the horns 53 and 54 in at least two directions in a plane of the bonding surface 20a of the electronic part 20 to be mounted on the to-be-bonded surface 10a of the circuit board 10. The bonding technique of applying ultrasonic vibrations in at least two directions in one plane prevents a chip-like electronic part from being damaged by ultrasonic vibrations in a (vertical) direction perpendicular to the bonding surface of the electronic part. Therefore, the yield of ultrasonic bonding can be improved, and the reliable and stable circuit operation can be maintained after the part is mounted. In addition, since the directions of the vibrations are varied in a plane of the bonding surface of the electronic part, electronic part can be mounted stably and reliably at a high uniform bonding strength relative to the pattern arrangement in all directions.

In the above embodiment, the first horn 53 and the second horn 54 are crossed to assemble the ultrasonic bonding tool 50. However, the ultrasonic bonding tool may be variously modified as far as ultrasonic vibrations can be applied in a plurality of directions in one plane, such as a structure in which three ultrasonic vibrators are provided on the vertexes of a Y-shaped bonding tool to generate ultrasonic vibrations in three directions.

## Claims

1. An electronic part mounting apparatus **characterized by** comprising:
pressurizing means (30) for pressurizing a bonding surface of an electronic part to a to-be-bonded surface of a circuit board, while holding the electronic part to be mounted on the circuit board; and
vibration applying means (60) for applying vibrations in a plurality of directions in a plane of the bonding surface of the electronic part, while holding the electronic part;
whereby the pressurizing means and the vibration applying means are adapted to bond the bonding surface of the electronic part to the to-be-bonded surface of the circuit board, thereby mounting the electronic part on the circuit board.

2. The electronic part mounting apparatus according to claim 1, **characterized in that** the pressurizing means comprises:
a bonding tool (50) having a pair of horns which are crossed, and a nozzle provided in an intersection portion of the horns to attract and hold the electronic part; and
pressure control means for pressurizing the bonding surface of the electronic part held by the nozzle of the bonding tool to the to-be-bonded surface of the circuit board.

3. The electronic part mounting apparatus according to claim 1, **characterized in that** the pressurizing means comprises:
a bonding tool (50) having a first horn provided with a first vibrator at one end in a longitudinal direction thereof, a second horn provided with a second vibrator at one end in a longitudinal direction thereof, and a nozzle which attracts and holds the electronic part, the first horn and the second horn crossing with each other, and the nozzle being provided at an intersection portion of the first horn and the second horn; and
vibration control means for causing the first vibrator to vibrate the bonding surface of the electronic part fixed to the nozzle in a first direction in a plane of the to-be-bonded surface of the circuit board, and causing the second vibrator to vibrate the bonding surface in a second direction in the plane of the to-be-bonded surface of the circuit board.

4. The electronic part mounting apparatus according to claim 3, **characterized in that** the vibration applying means comprises control means for alternately driving the first vibrator and the second vibrator.

5. The electronic part mounting apparatus according to claim 3, **characterized in that** the vibration applying means comprises control means for driving the first vibrator and the second vibrator at frequencies different from each other.

6. The electronic part mounting apparatus according to claim 3, **characterized in that** the vibration applying means comprises control means for driving the first vibrator and the second vibrator with a predetermined phase difference therebetween.

7. An electronic part mounting method for mounting an electronic part on a circuit board **characterized by** comprising:
a step of pressurizing a bonding surface of the electronic part to a to-be-bonded surface of the circuit board, in a state where the electronic part is being held to the circuit board; and
a step of applying ultrasonic vibrations in a plurality of directions in a plane of the bonding surface of the electronic part, thereby bonding the bonding surface of the electronic part to the to-be-bonded surface of the circuit board.

8. The electronic part mounting method according to claim 7, **characterized in that** the ultrasonic vibrations are applied by a bonding tool having a pair of horns which are crossed, and vibrators each provided at an end of each of the pair of horns.

9. The electronic part mounting method according to claim 8, **characterized in that** the ultrasonic vibrations are applied **in that** they are alternately driven in a predetermined time unit, thereby applying ultrasonic vibrations in two directions in the plane of the bonding surface of the electronic part.

10. An electronic circuit apparatus **characterized by** comprising:
a circuit board (10) having a to-be-bonded surface; and
an electronic part (20) having a bonding surface which is bonded the to-be-bonded surface of the circuit board, and mounted on a mount position of the circuit board by receiving vibrations in a plurality of directions in a plane of the bonding surface, so that the bonding surface is bonded to the to-be-bonded surface of the circuit board.

11. The electronic circuit apparatus according to claim 10, **characterized in that** the electronic part is a semiconductor device having a plurality of plated electrodes arranged in a matrix on the bonding surface.

12. The electronic circuit apparatus according to claim 10 or 11, **characterized in that** the circuit board is a flexible circuit board or a rigid circuit board.
